# EUROPÄISCHE PATENTSCHRIFT

(11) **EP 3 054 480 B1**
(45) Veröffentlichungstag und Bekanntmachung des Hinweises auf die Patenterteilung: **03.08.2022**
(21) Anmeldenummer: 15200325.7
(22) Anmeldetag: 16.12.2015
(51) Int. Cl.: H01L 23/49, H01L 23/34, H01L 25/07, H01L 23/00, H01L 23/495

(54) **KONTAKTANORDNUNG UND LEISTUNGSMODUL**
CONTACT ASSEMBLY AND POWER MODULE
SYSTEME DE CONTACT ET MODULE DE PUISSANCE

(30) Priorität: 14.01.2015 DE 102015200485
(43) Veröffentlichungstag der Anmeldung: 10.08.2016
(73) Patentinhaber: Robert Bosch GmbH, 70442 Stuttgart (DE)
(72) Erfinder: Jerg, Juergen, 72131 Ofterdingen (DE); Schaible, Dietmar, 71088 Holzgerlingen (DE); Turki, Jamel-Eddine, 72762 Reutlingen (DE); Orso, Steffen, 72764 Reutlingen (DE); Baer, Alexander, 72760 Reutlingen (DE); Adam, Boris, 71126 Gaeufelden (DE); Keil, Manuela, 72622 Nuertingen (DE)

(56) Entgegenhaltungen:
- DE-A1- 19 612 838
- JP-A- 2012 028 674
- US-A1- 2003 162 382

## Beschreibung

Die Erfindung betrifft eine Kontaktanordnung zwischen zumindest einem elektrischen und/oder elektronischen Bauelement und einem Verbindungselement sowie ein die Kontaktanordnung umfassendes elektronisches Leistungsmodul.

### Stand der Technik

In elektrischen und/oder elektronischen Anwendungen sind elektrische und/oder elektronische Bauelemente auf einem Schaltungsträger angeordnet und mit einer auf dem Schaltungsträger ausgebildeten Schaltung verbunden. Die elektrischen und/elektronischen Bauelemente weisen dabei elektrische Anschlüsse auf. Diese können beispielsweise derart ausgeführt sein, dass sie unmittelbar mit Kontaktstellen auf dem Schaltungsträger verbunden werden können, beispielsweise mittels einer Lot-, Sinter- oder Kleberschicht. Ebenso können Verbindungselemente verwendet werden, wie beispielsweise Drahtbonds oder Bändchenbond, welche von ihrer einen Seite her den elektrischen Anschluss des elektrischen und/oder elektronischen Bauelementes kontaktieren. Mit ihrer anderen Seite ist dann eine Kontaktstelle auf dem Schaltungsträger oder ein elektrischer Anschluss eines anderen Bauelementes oder überhaupt ein anderes Kontaktelement kontaktiert. Gerade bei SMD-Bauelementen gibt es Ausführungsvarianten, bei welchen die SMD-Bauelemente mit einer Unterseite beispielsweise mit einem Schaltungsträger verbunden werden, während eine Oberseite einen elektrischen Anschluss zur Kontaktierung mit beispielsweise einem Drahtbond oder einem Bändchenbond bereithält. Elektrische Anschlüsse weisen in vielen Fällen eine Kontaktoberfläche auf, welche aus Ag, einer Ag-Legierung, Au oder einer Au-Legierung gebildet ist. Diese ist beispielsweise als Metallisierungen aufgebracht und weist eine sehr gute elektrische Leitfähigkeit auf.

Aus der Verbindungstechnik sind Drahtbonds und/oder Bändchenbond aus unterschiedlichen Materialien bekannt. Beispielsweise können diese aus Al oder aus einer AI-Legierung gebildet sein. Ebenso sind Materialien aus Au, einer Au-Legierung, Cu, einer Cu-Legierung, Ag oder einer Ag-Legierung im Einsatz. Neben einer elektrischen Leitfähigkeit zeichnen einen Bondkontakt auch die Haftfestigkeit und die zuverlässige elektrische Verbindung über die Lebensdauer aus. Durch die Qualität des Bondkontaktes ist insgesamt auch die Funktionalität der elektrischen Schaltung beeinflusst.

Nachteilig ist, dass bei manchen Bondkontakten über längere Zeit eine Korrosionswirkung festzustellen ist. Insbesondere sind intermetallische Phasen sehr korrosionsanfällig, welche sich zwischen der Metallisierung der elektrischen Anschlüsse eines elektrischen und/oder elektronischen Bauelementes und einem Drahtbond oder einem Bändchenbond im Bondkontakt ausbilden. Gerade Halogenide oder Ionen wie Flour (F⁻), Chlor (Cl⁻), Iod (I⁻) oder aber Brom (Br⁻) und Schwefel (S) bzw. Sulfate (SO₄²⁻) sind bekannt für ihre korrodierende Wirkung auf verschiedene Metallkombinationen. Die korrodierenden Stoffe können zum einen durch die Verwendung von beispielsweise Moldmasse, welche den Bondkontakt mit umschließt, eingetragen werden. Ebenso sind Querkontaminationen während einer Prozessfertigung eines den Bondkontakt aufweisendes elektrisches und/oder elektronisches Bauelement hierfür verantwortlich.

Eine weitere Problematik ergibt sich dadurch, dass nicht alle elektrischen Anschlüsse eines elektrischen und/oder elektronischen Bauelements in der Weise einfach bondbar sind, dass sie zum einen eine ausreichende oder zufriedenstellende Haftung und zum anderen eine ausreichend dimensionierte mechanische Festigkeit für das Anbringen eines Drahtbondes oder eines Bändchenbonds aufweisen.

Aus der Offenlegungsschrift DE 3328114 A1 ist eine Auslösevorrichtung für ein Rückhaltesystem in Kraftfahrzeugen bekannt. Hierbei ist auf einer Metallplatte ein Verzögerungsaufnehmer befestigt. Ein Masseanschluss wird dadurch erreicht, indem eine Elektrode des Verzögerungsaufnehmers mit der Metallplatte verbunden wird. Der Verzögerungsaufnehmer ist als (Doppel-) Piezostreifen ausgebildet. Um eine zweite Elektrode des Verzögerungsaufnehmers zu kontaktieren, sind auf dieser ein Lötplättchen und ein nicht näher bezeichnetes Bondplättchen aufgebracht.

Aus der Offenlegungsschrift DE 196 12 838 A1 ist eine Kontaktanordnung bekannt, bei welcher ein Kontaktplättchen zwischen einem Bonddraht und einem Anschluss angeordnet ist, um so eine Rissbildung oder eine mechanische Stabilität zu verbessern. Das Kontaktplättchen ist dabei aus Molybdän vorgesehen.

Die Offenlegungsschrift US 2003 016 23 82 A1 zeigt eine Kontaktanordnung mit einem Kontaktplättchen und einem Bonddraht aus Gold. Das Kontaktplättchen ist dabei aus Kupfer gebildet, bei dem eine Beschichtung aus Gold, Silber oder Palladium vorgesehen ist.

### Offenbarung der Erfindung

### Vorteile

Der Erfindung liegt die Aufgabe zu Grunde, die Kontaktierung eines elektrischen und/oder elektronischen Bauelementes mit einem Verbindungselement hinsichtlich einer Korrosionsanfälligkeit zu verbessern. Ferner ist es eine Aufgabe, die Hafteigenschaften sowie die mechanische Grundlage einer Kontaktierung des Verbindungselementes insgesamt zu erhöhen bzw. zu begünstigen.

Diese Aufgabe wird durch eine Kontaktanordnung zwischen zumindest einem elektrischen und/oder elektronischen Bauelement und einem Verbindungselement sowie ein die Kontaktanordnung umfassendes elektronisches Leistungsmodul mit den kennzeichnenden Merkmalen der unabhängigen Ansprüche gelöst.

Die erfindungsgemäße Kontaktanordnung umfasst mindestens ein elektrisches und/oder elektronisches Bauelement, wobei das elektrische und/oder elektronische Bauelement zumindest einen ersten und einen zweiten elektrischen Anschluss aufweist und diese jeweils eine Kontaktoberfläche zum mittelbaren oder unmittelbaren elektrischen Kontaktieren des elektrischen und/oder elektronischen Bauelementes mit einer Schaltung umfassen. Mindestens einer der Kontaktoberflächen ist dabei mit zumindest einem Verbindungselement verbunden, welches das mindestens eine elektrische und/oder elektronische Bauelement mit der Schaltung verbindet.

Kennzeichnend für die erfindungsgemäße Kontaktanordnung ist, dass zumindest eine der Kontaktoberflächen und das jeweilige zumindest eine Verbindungselement oder eine Beschichtung des jeweiligen zumindest einen Verbindungselementes jeweils aus einem Material gebildet sind, welche zusammen eine Materialpaarung aus Ag oder einer Ag-Legierung mit Al oder einer Al-legierung oder eine Materialpaarung aus Au oder einer Au-Legierung mit Al oder einer Al-Legierung ergeben. Zur Vermeidung einer Kontaktkorrosion ist dabei die zumindest eine Kontaktoberfläche mit einer ersten Seite eines Kontaktplättchens kontaktiert, während eine zweite Seite des Kontaktplättchens mit dem jeweiligen zumindest einen Verbindungselement kontaktiert ist. Dabei ist das Kontaktplättchen aus Wolfram gebildet. In vorteilhafter Weise ergeben sich durch Zwischenschalten des Kontaktplättchen an dessen Verbindungsstellen mit den elektrischen Anschlüssen des elektrischen und/oder elektronischen Bauelementes bzw. mit dem Verbindungselement jeweils eine neue Materialpaarung, welche weniger korrosionsanfällig ist. Der Hintergrund hierfür ist, dass die jeweiligen Materialien der neuen Materialpaarungen in ihren Elektronegativitäten einen geringeren Unterschied aufweisen. Die bevorzugt elektrische Kontaktierung des Verbindungselementes mit dem elektrischen und/oder elektronischen Bauelement erfolgt demnach mittelbar über das Kontaktplättchen, wodurch die gebildete Kontaktanordnung eine deutlich verbesserte Betriebssicherheit aufzeigt. Ferner ist durch das Kontaktplättchen die mechanische Beanspruchbarkeit für eine Verbindung des elektrischen und/oder elektronischen Bauelementes vorteilhaft erhöht. Demnach ist das elektrische und/oder elektronische Bauelement und/oder deren elektrische Anschlüsse vor mechanischen und thermomechanischen Belastungen besser geschützt, insbesondere bei Kontaktierungsvorgängen mit Verbindungselementen, bei welchen bekanntlich kurzzeitig hohe Kontaktierungskräfte erforderlich sind. Erfindungsgemäß können sich die Materialpaarungen aus der Kontaktierung von entsprechenden Beschichtungen ergeben, welche auf der ersten und/oder der zweiten Seite des Kontaktplättchens aufgetragen sind. Für diesen Fall kann das Grundmaterial des Kontaktplättchens auch derart gewählt werden, dass das Beschichtungsmaterial einfach und günstig durch bekannte Verfahren auf das Kontaktplättchen aufgetragen werden kann.

Anders als die Erfindung ist es auch möglich das Kontaktplättchen aus Cu, einer Cu-Legierung, Ni oder einer Ni-Legierung oder Molybdän vorzusehen. Ebenso abweichend ist es möglich, dass die erste und/oder die zweite Seite des Kontaktplättchens eine Beschichtung aufweist, welche aus Cu, einer Cu-Legierung, Ni oder einer Ni-Legierung, aus Wolfram oder aus Molybdän gebildet ist. Als eine mögliche Cu-Legierung ist dann beispielsweise CuSn 0,15, CuSn6, CuFeP vorgesehen, während als Ni-Legierung NiP oder NiV vorteilhaft geeignet ist. Ebenso abweichend ist eine Ausführungsform umfassend ein Kontaktplättchen aus Al oder einer AI-Legierung. Dies ist nur dann ermöglicht, wenn das Kontaktplättchen aus Al oder einer AI-Legierung mittels eines elektrisch leitfähigen Klebers auf die zumindest eine Kontaktoberfläche aufgebracht ist und somit insgesamt von dieser galvanisch getrennt bleibt.

In einer Weiterbildung der Erfindung oder einer alternativen Ausführung weist die zweite Seite des Kontaktplättchens eine Beschichtung auf, welche aus Pd oder einer Pd-Legierung oder aus Ag oder einer Ag-Legierung gebildet ist. In vorteilhafter Weise sind das weitere Materialien, welche eine günstige Haftgrundlage für ein Verbindungselement bei hervorragender elektrischer Leitfähigkeit zeigen. Zusätzlich ist hinsichtlich einer Verbindung mit dem Verbindungselement die Korrosionsanfälligkeit für die sich ergebende Kontaktanordnung sehr gering. Anders als die Erfindung ist es auch ermöglicht, die zweite Seite des Kontaktplättchens mit der genannten Beschichtung dann vorzusehen, wenn das Kontaktplättchen selbst und demnach auch dessen erste Seite aus Cu, einer Cu-Legierung, Ni oder einer Ni-Legierung oder aus Molybdän gebildet ist. Ebenso anders als die Erfindung kann dies erfolgen, wenn die erste Seite ebenfalls eine Beschichtung aufweist, wobei das Kontaktplättchen außer aus Cu, einer Cu-Legierung, Ni oder einer Ni-Legierung auch aus einem anderen Material gebildet ist, welches eine guten Beschichtbarkeit für die genannten Materialien der Beschichtungen für die erste und die zweite Seite des Kontaktplättchens aufweist.

Bevorzugt weist das Kontaktplättchen eine Dicke in einem Bereich von 0,1 mm - 10 mm auf. Die auf der ersten und/oder zweiten Seite des Kontaktplättchens aufgebrachte Beschichtung liegt bevorzugt in einem Dickenbereich von 0,5 µm - 1000 µm. Die Beschichtungen können beispielsweise durch (Walz-) Plattieren, eine galvanische Beschichtung, ein Dünnschichtverfahren wie beispielsweise PVD oder CVD oder einem Aufdampfen, einem Spritzverfahren wie Plasmaspritzen oder Kaltgasspritzen, auf die erste und/oder zweite Seite des Kontaktplättchens aufgetragen werden.

Insgesamt ist erfindungsgemäß der Vorteil gegeben, dass durch Vorsehen des Kontaktplättchens eine oxidationsträge Oberfläche zur Kontaktierung mit einem Verbindungselement vorliegt. Folglich sind die Hafteigenschaften für ein zu kontaktierendes Verbindungselement in vorteilhafter Weise optimiert.

Grundsätzlich umfasst das Verbindungselement mindestens einen Drahtbond oder ein Bändchenbond. Dabei ist der mindestens eine Drahtbond oder das mindestens eine Bändchenbond aus Al oder einer AI-Legierung (beispielsweise aus AICu, AISi, AlSiCu, AlMg) gebildet. In diesem Fall kommen alle für die Erfindung zuvor genannten Beschichtungen auf die zweite Seite des Kontaktplättchens in Frage. Eine Beschichtung aus Ag oder einer Ag-Legierung wird vorgesehen bei der Verwendung von zumindest einem Drahtbond oder einem Bändchenbond aus Au oder Ag bei gleichzeitigem Vorliegen der Kontaktoberfläche mit einer Metallisierung aus Al oder einer Al-Legierung. Erfindungsgemäß sind nun für die Kontaktierung mit einem Drahtbond oder einem Bändchenbond ideale Voraussetzung hinsichtlich derer Hafteigenschaften und einer dauerhaften Korrosionsbeständigkeit innerhalb der vorgeschlagenen Kontaktanordnung geschaffen. Ebenso hinsichtlich einer mechanischen Festigkeit für eine Bondbarkeit unter starker mechanischer Belastung, insbesondere für das elektrische und/oder elektronische Bauelement.

Da bei der erfindungsgemäßen Kontaktanordnung die zumindest eine Kontaktoberfläche auch aus Ag oder einer Ag-Legierung gebildet ist, könnten für die Kontaktanordnung weiterhin elektrische und/oder elektronische Bauelemente verwendet werde, welche an ihren elektrischen Anschlüssen gängige Metallisierungen aufweisen.

Besondere Vorteile ergeben sich bei einer Kontaktanordnung, bei welcher das mindestens eine elektrische und/oder elektronische Bauelement ein passives Bauelement, insbesondere ein MLCCs, ein NTC, ein PCT oder ein Shunt, oder ein aktives Bauelement, insbesondere ein Leistungshalbleiter, eine Diode oder ein Sensor, ist. Es zeigt sich, dass die Kontaktanordnung für eine Vielzahl von Anwendungsfällen vorteilhaft eingesetzt werden kann. Besonders bevorzugt ist das elektronische und/oder elektrische Bauelement ein Temperatursensor. Der Temperatursensor ist dabei selbst bevorzugt auf einer Oberseite eines Leistungshalbleiters, insbesondere einem Leistungs-MOSFET oder einem IGBT oder einem Leistungstransistor oder einer Leistungsdiode, angeordnet. Diese sind üblicherweise Bestandteil eines Leistungsmoduls, welches dann beispielsweise in der Funktion als Gleichrichter, Wechselrichter oder als Umrichter erfindungsgemäß besonders vorteilhaft betrieben werden kann. Eine Unterseite des Leistungshalbleiters ist dann beispielsweise mit einem Schaltungsträger der Schaltung verbunden ist. Der Temperatursensor ist ausgebildet, eine Temperatur des Leistungshalbleiters zu ermitteln und ein Temperatursignal bereitzustellen, welches als Regelgröße für einen maximalen Strom in dem zumindest einem Leistungshalbleiter dient. Der Temperatursensor ist demnach vertikal zum Leistungshalbleiter auf diesem angeordnet. Dies kann unmittelbar durch eine direkte Kontaktierung von Temperatursensor und der Oberseite des Leistungshalbleiters erfolgen. Ebenso ist eine mittelbare Kontaktierung derart denkbar, indem zwischen dem Leistungshalbleiter und dem Temperatursensor schaltungstechnisch vorgesehene Bauteile und/oder Bauelemente zwischengeschaltet sind. Insbesondere ist der Temperatursensor bevorzugt über eine Verbindungsschicht unmittelbar oder mittelbar auf der Oberseite des Leistungshalbleiters angeordnet, wobei die Verbindungsschicht insbesondere eine hohe Wärmeleitfähigkeit aufweist, um den thermischen Widerstand bis zum Temperatursensor bestmöglich klein zu halten. Grundsätzlich ist erfindungsgemäß der Temperatursensor in vorteilhafter Weise thermisch eng an den Leistungshalbleiter gekoppelt. Insbesondere können nun die Abstände zueinander so kurz gehalten werden, dass die Temperatur am Leistungshalbleiter und die Temperatur am Temperatursensor sich identisch entsprechen. Ebenso kann durch die erfindungsgemäße Ausführung von einem zeitnahen Temperaturangleich zwischen Temperatursensor und dem Leistungshalbleiter ausgegangen werden. In vorteilhafter Weise kann somit jederzeit der exakte Temperaturwert des Leistungshalbleiters durch den Temperatursensor ermittelt werden. Dies hat zu Folge, dass eine reale Temperaturüberwachung des Leistungshalbleiters erfolgen kann und dieser bis kurz vor Erreichen von für den Betrieb als kritisch einzustufenden Temperaturwerten mit maximalen Strömen betrieben werden kann. Dadurch ist in Berücksichtigung der Temperatur der Leistungshalbleiter bis zu seiner maximalen Stromtragfähigkeit ausgenutzt.

Eine bevorzugte Ausführungsform sieht vor, dass der Temperatursensor durch mindestens einen NTC (Negative Temperature Coefficient Thermistors), einen PTC (Positive Temperature Coefficient Thermistors) oder eine Diode gebildet ist. Derartige Bauelemente sind besonders gut als Temperatursensor geeignet und können insbesondere als SMD-Bauteile bezogen werden, wodurch eine sehr einfache Anordnung mittelbar oder unmittelbar auf dem Leistungshalbleiter ermöglicht ist. Zusätzlich ist von Vorteil, wenn diese insbesondere ungehäust ausgeführt sind. Auf diese Weise ist eine Temperaturangleichung an die Temperatur des Leistungshalbleiters besonders günstig gegeben.

Eine vorteilhafte Ausführungsform sieht vor, dass der zumindest eine Leistungshalbleiter als ungehäuster Chip ausgebildet ist. Derartige Ausführungen sind beispielsweise als bare-die bekannt. Auf diese Weise kann die Temperatur des Leistungshalbleiters ungehindert und über sehr kurze Wege bis zum Temperatursensor gelangen, so dass eine Verfälschung oder eine Verzögerung einer Temperaturmessung durch den Temperatursensor vorteilhaft reduziert, wenn nicht sogar nahezu ausgeschlossen ist.

Weiterhin ergibt sich eine vorteilhafte Ausführungsform, bei welcher die Oberseite des zumindest einen Leistungshalbleiters mit einem metallischen Clip elektrisch kontaktiert ist und der Temperatursensor auf dem metallischen Clip in unmittelbarer Nähe zur Oberseite des zumindest einen Leistungshalbleiter angeordnet ist. Dadurch ist der Vorteil gegeben, dass der Leistungshalbleiter über den metallischen Clip wirkungsvoll entwärmt werden kann. Auf diese Weise können im Vergleich zu einer Ausführung ohne zusätzlicher Entwärmung des Leistungshalbleiters dieser bis zur Erreichung einer gleichen Temperatur mit höheren Strömen angesteuert bzw. geregelt werden. Zeitgleich gewährt der metallische Clip durch seine günstige thermische Leitfähigkeit weiterhin einen nahezu ungehinderten Temperaturübertrag auf den Temperatursensor. Darüber hinaus wird durch den metallischen Clip eine räumliche und zeitliche Ausgleichsstreuung der Temperatur des Leistungshalbleiters bewirkt, wodurch sich ausgehend vom Temperatursensor insgesamt eine günstigere Signaldynamik zur Ausregelung beziehungsweise Begrenzung der maximalen Ströme für den Leistungshalbleiter ergibt. Bevorzugt ist der metallische Clip aus Kupfer oder einer Kupferlegierung gebildet. Dieser lässt sich in einfacher Weise mit der Oberseite des Leistungshalbleiters verbinden, beispielsweise durch eine Lot-, Sinter- oder Kleberschicht.

In einer günstigen Ausführungsform ist der metallische Clip als Brücke ausgebildet, welche den zumindest einen Leistungshalbleiter mit mindestens einem weiteren Leistungshalbleiter elektrisch verbindet. Auf diese Weise können verschiedene Schaltungstopologien, beispielsweise in Form einer Brückenschaltung, für ein Leistungsmodul als Gleichrichter, Wechselrichter oder Umrichter realisiert werden. Die Brücke verbindet beispielsweise elektrische Anschlüsse gleich mehrerer Leistungshalbleiter mit dem gleichen elektrischen Potential.

In Weiterbildung dieser Ausführungsform mit dem metallischen Clip als Brücke ist für besondere Anwendungsvorgaben auch eine elektrische Isolation zwischen dem auf der Brücke angeordneten Temperatursensor und dem Leistungshalbleiter denkbar. Hierzu weist der metallische Clip als Brücke eine Isolationsschicht auf. Die Isolationsschicht kann beispielsweise aus einem elektrisch isolierenden Kunststoff oder durch eine Keramik ausgebildet sein. Besonders einfach ist eine Realisierung dadurch möglich, indem die Brücke als ein DBC (direct-bondedcopper) oder ein IMS (insulated-metal-substrat) vorgesehen wird. Hierbei wird in vorteilhafter Weise der Temperatursensor bereits durch das im DBC oder IMS enthaltende Isolationsmaterial elektrisch zum Leistungshalbleiter entkoppelt.

Bevorzugt ist eine Ausführungsform, bei welcher der Temperatursensor auf dem gleichen elektrischen Potential, insbesondere im Hochspannungskreis, anliegt, wie der zumindest eine Leistungshalbleiter. Hierfür ist zumindest eine der Kontaktoberflächen der elektrischen Anschlüsse des Temperatursensors mittelbar oder unmittelbar mit der Oberseite des Leistungshalbleiters elektrisch kontaktiert.

Bevorzugt liegt das erfindungsgemäß vorgesehene Verbindungselement am gleichen elektrischen Potential an, wie der erste oder der zweite elektrische Anschluss des Temperatursensors. Bei einer Ausführungsform der Erfindung, bei welcher die Oberseite eines Leistungshalbleiters über einen metallischen Clip elektrisch kontaktiert ist und der metallische Clip wiederum durch einen elektrischen Anschluss des Temperatursensors kontaktiert ist, kann in diesem Falle auch das zumindest eine Verbindungselement mit dem metallischen Clip verbunden sein. Dadurch sind insgesamt der Leistungshalbleiter und der Temperatursensor auf dem gleichen Potential anliegend. Gleiches gilt, wenn die Oberseite des Leistungshalbleiters unmittelbar mit einem der elektrischen Anschlüsse des Temperatursensors und ebenso mit dem Verbindungselement elektrisch kontaktiert ist. Ferner ist es ebenso denkbar, dass der Temperatursensor auf der Oberseite des Leistungshalbleiters mittelbar oder unmittelbar angeordnet ist, ohne dass die Oberseite mit einem der elektrischen Anschlüsse kontaktiert ist. Beispielsweise können hierbei der erste und der zweite elektrische Anschluss auf einer Oberseite des Temperatursensors ausgebildet sein, welche der Oberseite des Leistungshalbleiters abgewandt ist. Dabei kann der Temperatursensor auch eine Einhäusung umfassen, welche einerseits eine mittelbare oder unmittelbare Anordnung und eine Verbindung mit dem Leistungshalbleiter ermöglicht und andererseits den ersten und den zweiten elektrischen Anschluss freigibt, welche bevorzugt dann jeweils mittelbar über ein erfindungsgemäß vorgesehenes Kontaktplättchen - mit oder ohne einer Beschichtung - mit einem oben genannten zumindest einen Verbindungselement verbunden sind.

Grundsätzlich ist das Temperatursignal gebildet durch einen Spannungsabfall am Temperatursensor. Der Spannungsabfall ist als Spannungsdifferenz zwischen dem elektrischen Potential des ersten und dem elektrischen Potential des zweiten elektrischen Anschlusses des Temperatursensors messbar.

Denkbar ist dabei ein elektronisches Leistungsmodul, insbesondere ein Gleichrichter, ein Wechselrichter oder ein Umrichter, umfassend die zuvor beschriebene erfindungsgemäße Kontaktanordnung. Dabei weist das elektronische Leistungsmodul elektrische Außenkontakte auf, insbesondere als Signalpins. Dabei ist mindestens ein erster Außenkontakt mit dem Drahtbond, dem Bändchenbond oder dem metallischen Clip verbunden, welcher die Kontaktoberfläche des ersten elektrischen Anschlusses des Temperatursensors mittelbar oder unmittelbar kontaktiert. Ferner ist mindestens ein zweiter Außenkontakt mit dem Drahtbond, dem Bändchenbond oder dem metallischen Clip verbunden, welcher die Kontaktoberfläche des zweiten elektrischen Anschlusses des Temperatursensors mittelbar oder unmittelbar kontaktiert. Hierbei ist der Spannungsabfall dann am Temperatursensor über die Spannungsdifferenz zwischen dem ersten und dem zweiten Außenkontakt als Temperatursignal abgreifbar. Der Temperatursensor ist somit im Leistungsmodul integriert und eine Berücksichtigung des Temperatursignals durch entsprechende Verdrahtung des Leistungsmodules in einer Schaltung gewährleistet.

Das Leistungsmodul weist eine Einhäusung auf, welche bevorzugt aus einer Moldmasse gebildet ist.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Fig. 1:: ein Ausführungsbeispiel einer erfindungsgemäßen Kontaktanordnung eines Temperatursensors und eines Verbindungselementes in einer Seitenschnittdarstellung,
- Fig. 2:: ein Leistungsmodul in einer Draufsicht,

### Ausführungsformen der Erfindung

In den Figuren sind funktional gleiche Bauteile jeweils mit gleichen Bezugszeichen gekennzeichnet.

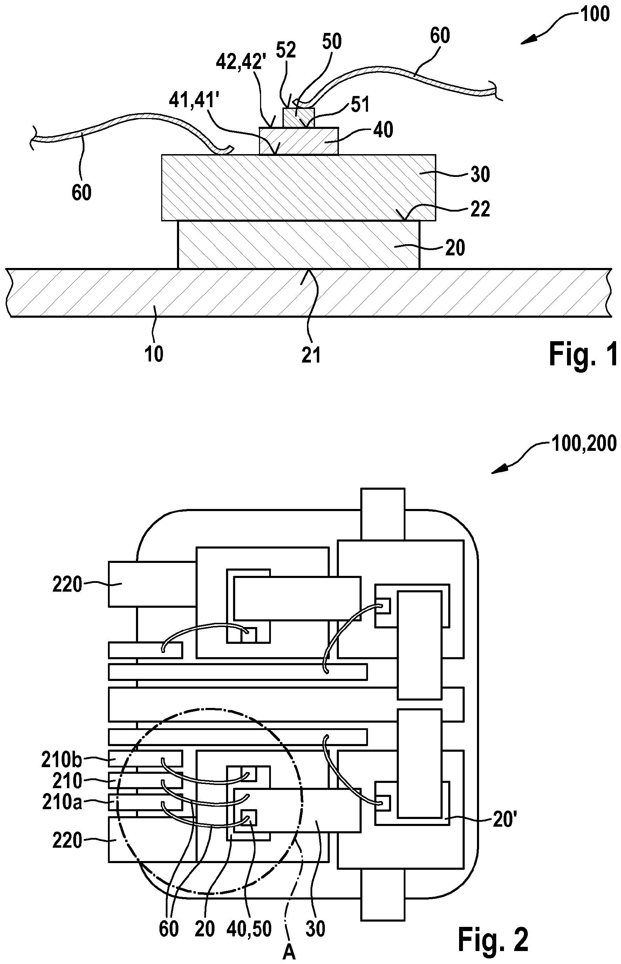

In Fig. 1 ist ein Ausführungsbeispiel einer erfindungsgemäßen Kontaktanordnung 100 gezeigt. Dabei ist auf einem Schaltungsträger 10, beispielsweise einem Stanzgitter oder einem PCB (printed circuit board), ein Leistungshalbleiter 20 angeordnet. Als Leistungshalbleiter 20 kann beispielsweise ein Leistungs-MOSFET oder ein IGBT oder ein Leistungstransistor vorgesehen sein. Der Leistungshalbleiter 20 weist eine Unterseite 21 und eine Oberseite 22 auf. Der Leistungshalbleiter 20 weist ebenso auf seiner Unterseite 21 und auf seiner Oberseite 22 jeweils zumindest einen elektrischen Anschluss (nicht dargestellt) auf. Über den elektrischen Anschluss auf der Unterseite 21 ist der Leistungshalbleiter 20 beispielsweise mit Leiterbahnen und/oder einer auf dem Schaltungsträger 10 ausgebildeten Schaltung insgesamt verbunden. Über die Oberseite 22 ist mittelbar ein weiteres elektrisches und/oder elektronisches Bauelement 40 vertikal über dem Leistungshalbleiter 20 angeordnet. Als elektrisches und/oder elektronisches Bauelement ist ein Temperatursensor 40 vorgesehen, bevorzugt als ein NTC-Bauteil. Zwischen dem Temperatursensor 40 und dem Leistungshalbleiter 20 ist ein metallischer Clip 30, insbesondere aus Cu oder einer Cu-Legierung, vorgesehen, welcher die Oberseite 22, insbesondere den dort vorliegenden elektrischen Kontakt des Leistungshalbleiters 20, elektrisch kontaktiert, beispielsweise mittels einer Lot-, Sinter- oder Kleberschicht. Der Temperatursensor 40 weist ebenso eine Oberseite und eine Unterseite auf, wobei auf der Unterseite zumindest in einem Bereich ein erster elektrischer Anschluss 41 und auf der Oberseite zumindest in einem Bereich ein zweiter elektrischer Anschluss 42 des Temperatursensors 40 ausgebildet ist. Die elektrischen Anschlüsse 41, 42 umfassen jeweils eine Kontaktoberfläche 41', 42' zum mittelbaren oder unmittelbaren Kontaktieren des Temperatursensors 40 mit beispielsweise der Schaltung auf dem Schaltungsträger 10. Die Kontaktoberflächen 41', 42' sind insbesondere aus Ag, einer Ag-Legierung, Au oder einer Au-Legierung, beispielsweise in Form einer auf die elektrischen Anschlüsse 41, 42 aufgebrachten Metallisierung gebildet. Der Temperatursensor 40 ist über seinen ersten elektrischen Kontakt 41 mittels der Kontaktoberfläche 41' mit dem metallischen Clip 30 elektrisch kontaktiert. Auf diese Weise liegt der Temperatursensor 40 auf dem gleichen elektrischen Potential an, insbesondere im Hochspannungskreis, wie der Leistungshalbleiter 20. Ferner ist der Temperatursensor 40 insgesamt in dieser Ausführung in unmittelbarer Nähe zur Oberseite 22 des Leistungshalbleiters 20 angeordnet. Der Temperatursensor 40 ist ausgebildet, eine Temperatur des Leistungshalbleiters 20 zu ermitteln und ein Temperatursignal bereitzustellen, welches als Regelgröße für einen maximalen Strom in dem zumindest einem Leistungshalbleiter 20 dient. Über die Kontaktoberfläche 42' des zweiten elektrischen Anschlusses 42 des Temperatursensors 40 ist zusätzlich eine erste Seite 51 eines Kontaktplättchen 50 kontaktiert, beispielsweise mittels einer Lot-, Sinter- oder Kleberschicht. Das Kontaktplättchen 50 ist aus Wolfram gebildet. Auf einer zweiten Seite 52 des Kontaktplättchen 50 ist optional noch eine Beschichtung aus Al, einer Al-Legierung, Pd oder einer Pd-Legierung aufgetragen. Die zweite Seite 52 des Kontaktplättchen 50 ist mit einem Verbindungselement 60 in Form zumindest eines Drahtbonds oder einem Bändchenbond aus Al oder einer Al-Legierung, kontaktiert. Ebenso ist der metallische Clip 30 mit zumindest einem oben genannten Verbindungselement 60 kontaktiert. Die Kontaktanordnung 100 ist beispielsweise Teil eines Leistungsmodules 200, welches in einer Draufsicht in der Fig. 2 dargestellt ist. Das Leistungsmodul 200 ist beispielsweise als Gleichrichter, Wechselrichter oder Umrichter ausgebildet und umfasst hierfür eine Brückenschaltung (nicht separat gezeigt). Neben dem oben genannten Leistungshalbleiter 20 sind noch weitere Leistungshalbleiter 20' innerhalb des Leistungsmoduls 200 enthalten, insbesondere in Ausbildung einer Brückenschaltung. Denkbar ist dabei ein Leistungsmodules 200, in welchem der metallische Clip 30 in Form einer Brücke ausgebildet ist, welche den Leistungshalbleiter 20, auf welchem der Temperatursensor 40 angeordnet ist, mit zumindest einem weiteren Leistungshalbleiter 20' verbindet. Das Leistungsmodul 200 umfasst ferner noch elektrische Außenkontakte 210, 220, welche beispielsweise als Signalpins 210 oder als Anschlüsse 220 für die Spannungsversorgung und Ansteuerung des Leistungsmoduls 200 ausgebildet sind. Der Ausschnitt A zeigt den Bereich des Leistungsmodules 200 in welchem der Temperatursensor 40 mittelbar über den metallischen Clip 30 mit der Oberseite 22 des Leistungshalbleiters 20 entsprechend der erfindungsgemäßen Kontaktanordnung 100 kontaktiert ist. Ferner ist das Kontaktplättchen 50 erkennbar, welches mit seiner ersten Seite 51 mit der Kontaktoberfläche 42' des zweiten elektrischen Anschlusses 42 des Temperatursensors 40 kontaktiert ist. Die zweite Seite 52 des Kontaktplättchens 50 ist dagegen mit dem einen Ende des Verbindungselementes 60 in Form des Drahtbonds oder des Bändchenbonds, kontaktiert. Das andere Ende des Verbindungselementes 60 ist wiederum mit einem Außenkontakt des Leistungsmodules 200, beispielsweise einem Signalpin 210a, verbunden. Das eine Verbindungselement 60, welchem mit seinem einen Ende am metallischen Clip 30 verbunden ist und somit am gleichen Potential anliegt, wie der erste elektrische Anschluss 41 des Temperatursensors 40, ist mit seinem anderen Ende ebenfalls mit einem Außenkontakt des Leistungsmodules 200, beispielsweise einem Signalpin 210b, verbunden. Über die Spannungsdifferenz zwischen den beiden Signalpins 210a, 210b ist dann der Spannungsabfall am Temperatursensor 40 als Temperatursignal abgreifbar. Das Ausführungsbeispiel gemäß den Fig. 1 kann entsprechend der beschriebenen Weiterbildungen oder Variationen für eine erfindungsgemäße Kontaktanordnung 100 verändert ausgeführt sein.

## Patentansprüche

1. Kontaktanordnung (100) umfassend mindestens ein elektrisches und/oder elektronisches Bauelement (40), wobei das elektrische und/oder elektronische Bauelement (40) zumindest einen ersten und einen zweiten elektrischen Anschluss (41, 42) aufweist und diese jeweils eine Kontaktoberfläche (41', 42') zum mittelbaren oder unmittelbaren elektrischen Kontaktieren des elektrischen und/oder elektronischen Bauelementes (40) mit einer Schaltung umfassen, wobei mindestens eine
der Kontaktoberflächen (41', 42') mit zumindest einem Verbindungselement (60) verbunden ist, welches das mindestens eine elektrische und/oder elektronische Bauelement (40) mit der Schaltung verbindet, wobei das Verbindungselement (60) mindestens einen Drahtbond oder ein Bändchenbond umfasst,
**dadurch gekennzeichnet, dass**
zumindest eine der Kontaktoberflächen (41', 42') aus Ag oder einer Ag-Legierung gebildet ist, und das jeweilige zumindest eine Verbindungselement (60) oder eine Beschichtung des jeweiligen zumindest einen Verbindungselementes (60) jeweils aus Al oder einer Al-Legierung gebildet ist, sodass zusammen eine Materialpaarung aus Ag oder einer Ag-Legierung mit Al oder einer Al-legierung gebildet ist, und dass zur Vermeidung einer Kontaktkorrosion die zumindest eine Kontaktoberfläche (41', 42') mit einer ersten Seite (51) eines Kontaktplättchen (50) kontaktiert ist, während eine zweite Seite (52) des Kontaktplättchen (50) mit dem jeweiligen zumindest einen Verbindungselement (60) kontaktiert ist, wobei das Kontaktplättchen (50) aus Wolfram gebildet ist.

2. Kontaktanordnung (100) umfassend mindestens ein elektrisches und/oder elektronisches Bauelement (40), wobei das elektrische und/oder elektronische Bauelement (40) zumindest einen ersten und einen zweiten elektrischen Anschluss (41, 42) aufweist und diese jeweils eine Kontaktoberfläche (41', 42') zum mittelbaren oder unmittelbaren elektrischen Kontaktieren des elektrischen und/oder elektronischen Bauelementes (40) mit einer Schaltung umfassen, wobei mindestens einer der Kontaktoberflächen (41', 42') mit zumindest einem Verbindungselement (60) verbunden ist, welches das mindestens eine elektrische und/oder elektronische Bauelement (40) mit der-Schaltung verbindet, wobei das Verbindungselement (60) mindestens einen Drahtbond oder ein Bändchenbond umfasst,
**dadurch gekennzeichnet, dass**
zumindest eine der Kontaktoberflächen (41', 42') aus Al oder einer Al-Legierung gebildet ist, und das jeweilige zumindest eine Verbindungselement (60) oder eine Beschichtung des jeweiligen zumindest einen Verbindungselementes (60) jeweils aus Au oder einer Au-Legierung gebildet sind, sodass zusammen eine Materialpaarung aus Au oder einer Au-Legierung mit Al oder einer Al-Legierung gebildet ist, und dass zur Vermeidung einer Kontaktkorrosion die zumindest eine Kontaktoberfläche (41', 42') mit einer ersten Seite (51) eines Kontaktplättchen (50) kontaktiert ist, während eine zweite Seite (52) des Kontaktplättchen (50) mit dem jeweiligen zumindest einen Verbindungselement (60) kontaktiert ist, wobei das Kontaktplättchen (50) aus Wolfram gebildet ist.

3. Kontaktanordnung (100) nach Anspruch 1,
**dadurch gekennzeichnet, dass**
die zweite Seite (51, 52) des Kontaktplättchens (50) eine Beschichtung aufweist, welche aus Ni oder einer Ni-Legierung gebildet ist.

4. Kontaktanordnung (100) nach Anspruch 2,
**dadurch gekennzeichnet, dass**
die zweite Seite (52) des Kontaktplättchens (50) eine Beschichtung aufweist, welche aus Pd oder einer Pd-Legierung gebildet ist.

5. Kontaktanordnung (100) nach Anspruch 1,
**dadurch gekennzeichnet, dass**
die zweite Seite (52) des Kontaktplättchens (50) eine Beschichtung aufweist, welche aus Ag oder einer Ag-Legierung gebildet ist.

6. Kontaktanordnung (100) nach einem der Ansprüche 1 oder 2,
**dadurch gekennzeichnet, dass**
das mindestens eine elektrische und/oder elektronische Bauelement (40) ein Sensor ist.

7. Kontaktanordnung (100) nach einem der vorhergehenden Ansprüche,
**dadurch gekennzeichnet, dass**
das mindestens eine elektrische und/oder elektronische Bauelement (40) ein Leistungshalbleiter ist.

8. Elektronisches Leistungsmodul (200), insbesondere ein Gleichrichter, ein Wechselrichter oder ein Umrichter, umfassend eine Kontaktanordnung (100) nach einem der vorhergehenden Ansprüche.

## Claims

1. Contact arrangement (100) comprising at least one electrical and/or electronic component (40), wherein the electrical and/or electronic component (40) has at least one first and one second electrical connection (41, 42) and these each comprise a contact surface (41', 42') for indirectly or directly electrically contact-connecting the electrical and/or electronic component (40) to a circuit, wherein at least one of the contact surfaces (41', 42') is connected to at least one connecting element (60) which connects the at least one electrical and/or electronic component (40) to the circuit, wherein the connecting element (60) comprises at least one wire bond or one ribbon bond,
**characterized in that**
at least one of the contact surfaces (41', 42') is formed from silver or a silver alloy, and the respective at least one connecting element (60) or a coating of the respective at least one connecting element (60) is respectively formed from aluminium or an aluminium alloy, so that together a material pairing consisting of silver or a silver alloy with aluminium or an aluminium alloy is formed, and **in that**, in order to avoid contact corrosion, the at least one contact surface (41', 42') is contact-connected to a first side (51) of the contact plate (50), while a second side (52) of the contact plate (50) is contact-connected to the respective at least one connecting element (60), wherein the contact plate (50) is formed from tungsten.

2. Contact arrangement (100) comprising at least one electrical and/or electronic component (40), wherein the electrical and/or electronic component (40) has at least one first and one second electrical connection (41, 42) and these each have a contact surface (41', 42') for indirectly or directly electrically contact-connecting the electrical and/or electronic component (40) to a circuit, wherein at least one of the contact surfaces (41', 42') is connected to at least one connecting element (60) which connects the at least one electrical and/or electronic component (40) to the circuit, wherein the connecting element (60) comprises at least one wire bond or one ribbon bond,
**characterized in that**
at least one of the contact surfaces (41', 42') is formed from aluminium or an aluminium alloy, and the respective at least one connecting element (60) or a coating of the respective at least one connecting element (60) is respectively formed from gold or a gold alloy, so that together a material pairing consisting of gold or a gold alloy with aluminium or an aluminium alloy is formed, and **in that**, in order to avoid contact corrosion, the at least one contact surface (41', 42') is contact-connected to a first side (51) of a contact plate (50), while a second side (52) of the contact plate (50) is contact-connected to the respective at least one connecting element (60), wherein the contact plate (50) is formed from tungsten.

3. Contact arrangement (100) according to Claim 1,
**characterized in that**
the second side (51, 52) of the contact plate (50) has a coating which is formed from nickel or a nickel alloy.

4. Contact arrangement (100) according to Claim 2, **characterized in that** the second side (52) of the contact plate (50) has a coating which is formed from palladium or a palladium alloy.

5. Contact arrangement (100) according to Claim 1,
**characterized in that**
the second side (52) of the contact plate (50) has a coating which is formed from silver or a silver alloy.

6. Contact arrangement (100) according to either of Claims 1 and 2,
**characterized in that**
the at least one electrical and/or electronic component (40) is a sensor.

7. Contact arrangement (100) according to one of the preceding claims,
**characterized in that**
the at least one electrical and/or electronic component (40) is a power semiconductor.

8. Electronic power module (200), in particular a rectifier, an inverter or a converter, comprising a contact arrangement (100) according to one of the preceding claims.

## Revendications

1. Système de contact (100) comprenant au moins un composant électrique et/ou électronique (40), dans lequel le composant électrique et/ou électronique (40) comporte au moins une première et une deuxième connexion électrique (41, 42) et celles-ci comprennent respectivement une surface de contact (41', 42') pour la mise en contact électrique directe ou indirecte du composant électrique et/ou électronique (40) avec un circuit, dans lequel au moins l'une des surfaces de contact (41', 42') est reliée à au moins un élément de liaison (60) qui relie ledit au moins un composant électrique et/ou électronique (40) au circuit, dans lequel l'élément de liaison (60) comprend au moins une liaison par soudage de fil ou une liaison par soudage de ruban,
**caractérisé en ce qu'**au moins l'une des surfaces de contact (41', 42') est formée d'Ag ou d'un alliage d'Ag, et ledit au moins un élément de liaison (60) respectif ou un revêtement dudit au moins un élément de liaison (60) respectif est respectivement formé d'Al ou d'un alliage d'Al, pour ainsi former ensemble un appariement de matériaux composé d'Ag ou d'un alliage d'Ag avec de l'Al ou un alliage d'Al, et **en ce que**, pour éviter une corrosion de contact, ladite au moins une surface de contact (41', 42') est en contact avec une première face (51) d'une plaquette de contact (50), tandis qu'une deuxième face (52) de la plaquette de contact (50) est en contact avec ledit au moins un élément de liaison (60) respectif, dans lequel la plaquette de contact (50) est formée de tungstène.

2. Système de contact (100) comprenant au moins un composant électrique et/ou électronique (40), dans lequel le composant électrique et/ou électronique (40) comporte au moins une première et une deuxième connexion électrique (41, 42) et celles-ci comprennent respectivement une surface de contact (41', 42') pour la mise en contact électrique directe ou indirecte du composant électrique et/ou électronique (40) avec un circuit, dans lequel au moins l'une des surfaces de contact (41', 42') est reliée à au moins un élément de liaison (60) qui relie ledit au moins un composant électrique et/ou électronique (40) au circuit, dans lequel l'élément de liaison (60) comprend au moins une liaison par soudage de fil ou une liaison par soudage de ruban,
**caractérisé en ce qu'**au moins l'une des surfaces de contact (41', 42') est formée d'Al ou d'un alliage d'Al, et ledit au moins un élément de liaison (60) respectif ou un revêtement dudit au moins un élément de liaison (60) respectif est respectivement formé d'Au ou d'un alliage d'Au, pour ainsi former ensemble un appariement de matériaux composé d'Au ou d'un alliage d'Au avec de de l'Al ou un alliage d'Al, et **en ce que**, pour éviter une corrosion de contact, ladite au moins une surface de contact (41', 42') est en contact avec une première face (51) d'une plaquette de contact (50), tandis qu'une deuxième face (52) de la plaquette de contact (50) est en contact avec ledit au moins un élément de liaison (60) respectif, dans lequel la plaquette de contact (50) est formée de tungstène.

3. Système de contact (100) selon la revendication 1, **caractérisé en ce que** la deuxième face (51, 52) de la plaquette de contact (50) comporte un revêtement qui est formé de Ni ou d'un alliage de Ni.

4. Système de contact (100) selon la revendication 2, **caractérisé en ce que** la deuxième face (52) de la plaquette de contact (50) comporte un revêtement qui est formé de Pd ou d'un alliage de Pd.

5. Système de contact (100) selon la revendication 1, **caractérisé en ce que** la deuxième face (52) de la plaquette de contact (50) comporte un revêtement qui est formé d'Ag ou d'un alliage d'Ag.

6. Système de contact (100) selon l'une des revendications 1 ou 2,
**caractérisé en ce que** ledit au moins un composant électrique et/ou électronique (40) est un capteur.

7. Dispositif de contact (100) selon l'une des revendications précédentes,
**caractérisé en ce que** ledit au moins un composant électrique et/ou électronique (40) est un semi-conducteur de puissance.

8. Module électronique de puissance (200), notamment un redresseur, un onduleur ou un convertisseur, comprenant un système de contact (100) selon l'une des revendications précédentes.
